Europäisches Patentamt

European Patent Office

Office européen des brevets

(11) Veröffentlichungsnummer: **0 373 376**
A2

## (12) EUROPÄISCHE PATENTANMELDUNG

(21) Anmeldenummer: 89121098.1

(22) Anmeldetag: 14.11.89

(51) Int. Cl.5: **G05B 19/417**

(30) Priorität: 15.12.88 DE 3842244

(43) Veröffentlichungstag der Anmeldung:
20.06.90 Patentblatt 90/25

(84) Benannte Vertragsstaaten:
AT BE CH DE FR GB IT LI NL

(71) Anmelder: **Siemens Aktiengesellschaft**
**Wittelsbacherplatz 2**
**D-8000 München 2(DE)**

(72) Erfinder: **Müller, Helmut, Dipl-Ing.**
**Paul-Lincke-Strasse 26**
**D-8900 Augsburg(DE)**
Erfinder: **Laussermair, Thomas, Dipl-Ing.**
**Friedlandstrasse 15**
**D-8034 Germering(DE)**

(54) **Verfahren zur Erzeugung einer optimalen Lötqualität bei Flachbaugruppen mittels rechnergesteuerter Lötautomaten.**

(57) Verfahren zur Erzeugung einer optimalen Lötqualität bei parametergesteuerten Lötautomaten für Flachbaugruppen (12) durch automatische Erstellung von Lötparametern in einem ersten Rechner (1) und eventuell neuer Lötparameter nach Überprüfung des Lötergebnisses im gleichen Rechner und Übergabe dieser Parameter in den Steuerrechner (3) des Lötautomaten.

EP 0 373 376 A2

## Verfahren zur Erzeugung einer optimalen Lötqualität bei Flachbaugruppen mittels rechnergesteuerter Lötautomaten

Die Erfindung betrifft ein Verfahren zur Erzeugung einer optimalen Lötqualität bei Flachbaugruppen die mit Hilfe eines, mittels eines Steuerrechners parametergesteuerten Lötautomaten verlötet und über Werkstückträger dem Lötautomaten zugeführt werden.

Die Ermittlung optimaler Einstellparameter für rechnergesteuerte Lötsysteme ist ein sehr aufwendiger und komplexer Prozeß. Die Parameterfixierung ist abhängig von den Konstruktionsmerkmalen des Lötgutes, der Maschinensteuerung und korreliert mit dem Lötergebnis. Die Ermittlung der Einstellparameter ist daher einigen wenigen Lötexperten vorbehalten. Die Parameter werden von diesen Lötexperten empirisch optimiert und manuell generiert.

Aufgabe der vorliegenden Erfindung ist es daher ein Verfahren anzugeben, durch das bei rechnergesteuerten Lötanlagen für Flachbaugruppen automatisiert eine optimale Lötqualität erreicht wird.

Zur Lösung dieser Aufgabe wird gemäß der Erfindung derart verfahren, daß mittels einer ersten Auswertevorrichtung sowohl der zu lötende Flachbaugruppentyp als auch die Werkstückträgerbelegung festgestellt, mittels dieser Kriterien aus einer Datenbank die entsprechenden Konstruktions- und Belegungsmerkmale entnommen und mittels eines Technologieregeln für die Lötparametergenerierung enthaltenden ersten Rechners Lötparameter erstellt werden, die dem Steuerrechner des Lötautomaten übergeben werden, daß die so gelöteten Flachbaugruppen in einer zweiten Auswerteeinrichtung auf Fehlermerkmale überprüft und das Ergebnis dem ersten Rechner übermittelt wird, der im Bedarfsfall daraus neue Lötparameter erstellt, die wiederum den Steuerrechner zugeführt werden und daß dieser iterative Prozeß fortgeführt wird bis eine Optimierung der Lötqualität erreicht ist.

Der Flachbaugruppentyp, die Werkstückträgerbelegung sowie die Fehlermerkmale werden dem ersten Rechner entweder im Dialog oder automatisch durch Bildauswertung mitgeteilt.

Vorteilhaft ist es auch, daß der erste Rechner eine Diskette erstellt, die dem Steuerrechner zugeführt wird.

Durch das Verfahren nach der Erfindung erhält man eine effiziente Lötparametergenerierung ohne Experten. Durch die Erhöhung der Lötqualität wird die Nacharbeit von Flachbaugruppen verringert und dadurch sowohl Energie als auch Material eingespart. Außerdem erlaubt dieses Verfahren die Nutzung der vollen Möglichkeit der rechnergesteuerten Lötsysteme.

Anhand eines Diagramms wird der Verfahrensablauf näher erläutert. Zunächst wird der unbestückte und ungelötete Flachbaugruppentyp 7 ermittelt und aus einer Datenbank 5 seine Konstruktionsmerkmale ausgesucht. Nachdem die unbestückte Flachbaugruppe 7 auf einem Bestückungswerkstückträger WTB befestigt ist wird diese in einem Bestückungsautomaten 8 bestückt und anschließend an einem Lötwerkstückträger WTL weitergegeben. Mit Hilfe einer Kamera 4 wird die Werkstückträgerbelegung ermittelt und nunmehr sowohl die Belegungsart als auch die Konstruktionsmerkmale einem ersten Rechner 1 zugeführt, der daraus nunmehr die erforderlichen Lötparameter ermittelt und diese z.B. über eine Diskette 2 dem Steuerrechner 3 für den Lötautomaten zuführt. Die der parametergesteuerten Lötanlage 9 zugeleitete bestückte Flachbaugruppe wird nunmehr gelötet und anschließend einem weiteren Prüfwerkstückträger WTP übergeben, der die Flachbaugruppe einer Prüfeinrichtung 10 zuführt. Dort wird die bestückte und gelötete Flachbaugruppe 12 überprüft, eventuelle Fehlerdaten mit Hilfe der Bildverarbeitung ermittelt und mit Hilfe eines Betriebsdatenerfassungssystems 11 die entsprechenden Werte wiederum an den ersten Rechner 1 weitergegeben, der daraus neue Parameter ermittelt, die nunmehr wieder dem Steuerrechner 3 zugeführt werden. Diese iterative Prozeßoptimierung wird solange wiederholt bis keine Verbesserung der Lötqualität mehr möglich ist.

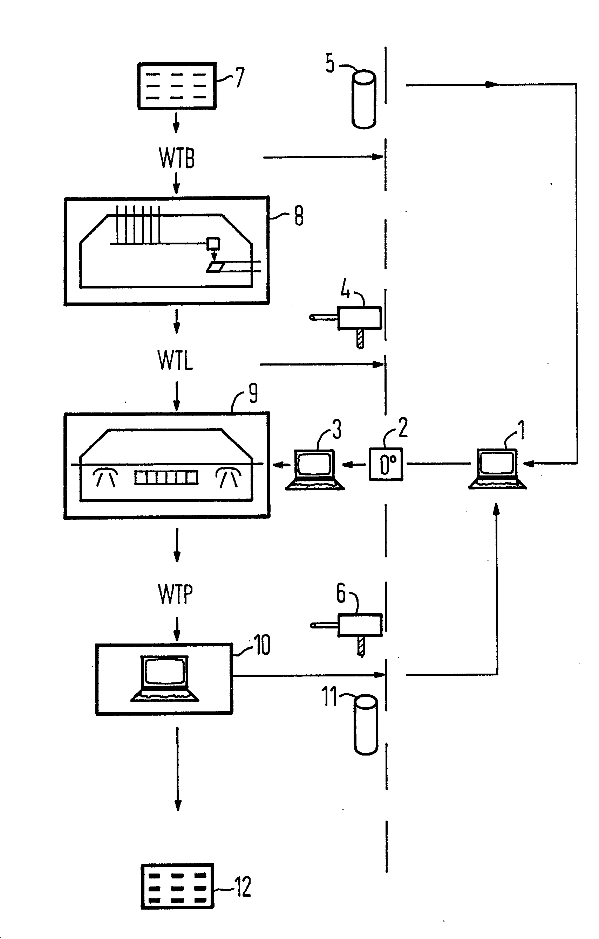

### Ansprüche

1. Verfahren zur Erzeugung einer optimalen Lötqualität bei Flachbaugruppen die mit Hilfe eines mittels eines Steuerrechners parametergesteuerten Lötautomaten verlötet und über Werkstückträger dem Lötautomaten zugeführt werden,
**dadurch gekennzeichnet,** daß mittels einer ersten Auswertevorrichtung (4) sowohl der zu lötende Flachbaugruppentyp (7) als auch die Werkstückträgerbelegung festgestellt, mittels dieser Kriterien aus einer Datenbank (5) die entsprechenden Konstruktions- und Belegungsmerkmale entnommen und mittels eines Technologieregeln für die Lötparametergenerierung enthaltenden ersten Rechners (1) Lötparameter erstellt werden, die dem Steuerrechner (3) des Lötautomaten übergeben werden, daß die so gelöteten Flachbaugruppen (12) in einer zweiten Auswerteeinrichtung (6) auf Fehlermerkmale überprüft und das Ergebnis dem ersten Rechner (1) übermittelt wird, der im Bedarfsfall daraus neue Lötparameter erstellt, die wiederum dem Steuerrechner (3) zugeführt werden und daß dieser iterative Prozeß fortgeführt wird bis eine Optimierung der Lötqualität erreicht ist.

2. Verfahren nach Anspruch 1,

**dadurch gekennzeichnet,** daß der Flachbaugruppentyp (7) und die Werkstückträgerbelegung sowie die Fehlermerkmale dem ersten Rechner (1) entweder im Dialog oder automatisch durch Bildauswertung mitgeteilt werden.

3. Verfahren nach einem der Ansprüche 1 oder 2,

**dadurch gekennzeichnet,** daß der erste Rechner (1) eine Diskette (2) erstellt, die dem Steuerrechner (3) zugeführt wird.